# EUROPÄISCHE PATENTSCHRIFT

(11) **EP 2 021 532 B1**
(45) Veröffentlichungstag und Bekanntmachung des Hinweises auf die Patenterteilung: **23.03.2011**
(21) Anmeldenummer: 07728836.3
(22) Anmeldetag: 07.05.2007
(51) Int. Cl.: C30B 25/14, C23C 16/458

(54) **QUELLENBEHÄLTER EINES VPE-REAKTORS**
SOURCE CONTAINER OF A VPE REACTOR
RÉCIPIENT SOURCE D'UN RÉACTEUR VPE

(30) Priorität: 15.05.2006 DE 102006022534
(43) Veröffentlichungstag der Anmeldung: 11.02.2009
(73) Patentinhaber: Aixtron SE, 52134 Herzogenrath (DE)
(72) Erfinder: FRANKEN, Walter, 52249 Eschweiler (DE); KÄPPELER, Johannes, 52146 Würselen (DE)
(74) Vertreter: Rieder, Hans-Joachim
(86) Internationale Anmeldenummer: PCT/EP2007/054383
(87) Internationale Veröffentlichungsnummer: WO 2007/131900

(56) Entgegenhaltungen:
- DE-A1- 10 247 921
- US-B1- 6 270 839

## Beschreibung

Die Erfindung betrifft eine Quellenanordnung für eine VPE-Beschichtungseinrichtung gemäß Gattungsbegriff des Anspruchs 1 sowie eine VPE-Beschichtungsvorrichtung gemäß Gattungsbegriff des Anspruchs 8.

Eine Quellenanordnung, bei der ein fester oder flüssiger Ausgangsstoff in einem Behälter bevorratet wird, welcher von einem Deckel derart abgedeckt ist, dass sich zwischen der Oberfläche des Ausgangsstoffs und dem Deckel ein Volumen ausbildet, beschreibt die US 6,270,839 B1. Durch das Volumen kann ein reaktives Gas parallel zur Oberfläche des durchströmbaren Volumens strömen, damit eine Reaktion zwischen dem reaktiven Gas und dem Ausgangsstoff stattfindet.

Die DE 3801147 A1 beschreibt ebenfalls eine Quellenanordnung. Dort liegt auf einer porösen Wandung eine Pulverschüttung. Auf dieser liegt eine poröse Platte auf. Die oben liegende poröse Platte wird mittels einer Feder auf die Pulverschüttung gedrückt, so dass Oberfläche immer parallel zur unteren Wandung verläuft.

Eine ähnliche Vorrichtung beschreibt die US 5,603,169. Hier liegt auf der Oberfläche der Schüttung eine gasdurchlässige Kompressionsplatte. Sie wird durch die Schwerkraft nivellierend auf die Oberfläche gepresst.

Die DE 10247921 A1 beschreibt einen Hydrid-VPE-Reaktor. Der dort beschriebene Reaktor besitzt ein Gehäuse. In dem Gehäuse befindet sich eine Prozesskammer mit einem Suszeptor zur Aufnahme eines oder mehrerer Substrate, die mit einem Halbleitermaterial beschichtet werden. Das Halbleitermaterial ist ein mehrkomponentiges Material und besitzt insbesondere Komponenten der III- und V-Hauptgruppe. Die Elemente der III-Hauptgruppe, beispielsweise Ga,In,Al werden in Form von Chloriden in die Prozesskammer eingeleitet. Die V-Komponenten werden als Hydride in die Prozesskammer eingeleitet. Insbesondere werden NH₃, AsH3 oder PH₃ in die Prozesskammer eingeleitet. Die Chloride werden in einer Quellenzone erzeugt. Diese Quellenzone wird beheizt. In die Quellenzone wird HCl eingeleitet. Dieses HCl wird über die Oberfläche der flüssigen oder festen Metallkomponente geleitet, so dass sich möglichst unter thermodynamischen Gleichgewichtsbedingungen die Chloride bilden. Durch den Abtransport der III-Komponente aus dem Quellenbehälter sinkt die Oberfläche des im Quellenbehälter enthaltenen Ausgangsstoffes ab. Dies hat eine Änderung der Effizienz des Quellenumsatzes zur Folge. Insbesondere bei kleinen Oberflächen, die bei vertikal durchströmten Quellenzonen nicht zu vermeiden sind, sind diese nicht konstanten Quellenumsätze nachteilig.

Der Erfindung liegt die Aufgabe zugrunde, Maßnahmen anzugeben, mit denen die Quellenreaktion zeitlich stabilisiert ist.

Gelöst wird die Aufgabe durch die in den Ansprüchen angegebene Erfindung.

Zunächst und im wesentlichen ist vorgesehen, dass der nach oben offene Behälter mit einem Deckel abgedeckt ist. Dieser Deckel soll auf dem Ausgangsstoff aufliegen. Zwischen Deckel und Oberfläche des Ausgangsstoffes soll sich ein ... vom reaktiven Gas durchströmbares Volumen ausbilden. Das reaktive Gas durchströmt das Volumen parallel zur Oberfläche des Ausgangsstoffes. In das Volumen mündet eine Zuleitung. Das aus der Zuleitung austretende Gas durchströmt somit zunächst das Volumen und überströmt dadurch die Oberfläche. Handelt es sich bei dem Ausgangsstoff um eine Flüssigkeit, so durchströmt das Gas das Volumen in Horiziontalrichtung. Indem der Deckel unmittelbar auf dem Ausgangsstoff aufliegt, bleibt der Abstand zwischen Unterseite des Deckels und Oberfläche des Ausgangsstoffes über die Zeit konstant und unabhängig von der Höhe des Flüssigkeits- oder Feststoffspiegels innerhalb der Quelle. Trotz stetigem Verbrauch der Quelle ändert sich das vom reaktiven Gas durchströmbare Volumen nur unwesentlich, da der Deckel mit dem Niveau der Oberfläche des Quellenmaterials absinkt. Die Quellenumsätze sind dadurch stabilisiert. Ist der Ausgangsstoff flüssig, so schwimmt der Deckel auf dem Ausgangsstoff. Zufolge vom Deckel abragender, auf dem Quellenmaterial sich abstützender Träger, insbesondere Schwimmer bildet sich das Durchströmungsvolumen aus. Die Träger/ Schwimmer können von lokalen Vorsprüngen ausgebildet sein. Sie werden insbesondere von nach unten ragenden Hohlkammern gebildet. Die Zuleitung, durch die das reaktive Gas unter den Deckel geleitet wird, befindet sich bevorzugt im Zentrum des Behälters. Der Behälter kann eine Rotationssymmetrie aufweisen. Das Volumen wird dann in Radialrichtung durchströmt. Der Deckel kann die Form einer Kreisscheibe aufweisen. Der Rand des Deckels kann einen Abstand zur Behälterwand besitzen. Durch den dadurch gebildeten Abstandsspalt kann das sich unterhalb des Deckels innerhalb des durchströmten Volumens gebildete Prozessgas abströmen. Die Mündung der Zuleitung wird bevorzugt von einem Dom des Deckels überfangen. So ist sichergestellt, dass auch bei niedrigstem Quellenmaterialniveau der Deckel nicht in Auflage auf die Mündung der Zuleitung kommt. Der Behälter und der Deckel sind aus einem Material gefertigt, welches nicht mit den Ausgangsstoffen bzw. den reaktiven oder Prozessgasen reagiert. So können Behälter und Deckel aus Quarz bestehen, wenn die Quelle Gallium oder Indium enthalten soll. Es bietet sich an, die Quelle und den Deckel aus Graphit zu fertigen, wenn die Quelle Aluminium aufnehmen soll. Die Graphitoberfläche ist dann vorzugsweise mit einem geeigneten Material beschichtet. Auch Saphir, Bornitrit oder andere Inertmaterialien können verwendet werden. Die Beschichtungsvorrichtung, die die zuvor beschriebene Quellenanordnung aufnimmt, besitzt bevorzugt eine Quellenzone, die in Vertikalrichtung durchströmt wird. Die Quellenzone kann sich in Vertikalrichtung erstreckende Wände, die insbesondere den Abschnitt eines Rohres ausbilden, aufweisen. Die Wände werden außen widerstandsbeheizt, so dass die Temperatur der Quelle einstellbar ist. Unterhalb der Quellenzone befindet sich die Prozesskammer. Diese erstreckt sich in Horizontalrichtung. Die in der Quellenzone gebildeten Prozessgase werden von oben nach unten in die Prozesskammer eingeleitet und durchströmen die Prozesskammer in Radialrichtung, so dass die Prozessgase in Horizontalrichtung die um das Zentrum gruppierten Substrate überstreichen. Auch das Hydrid wird im Zentrum der Prozesskammer eingeleitet. Die zuvor beschriebene Quellenanordnung kann aber nicht nur in vertikal durchströmten Quellenzonen, sondern auch in horizontal durchströmten Quellenzonen angeordnet sein.

Ausführungsbeispiele der Erfindung werden nachfolgend anhand beigefügter Zeichnungen erläutert. Es zeigen:
- Fig. 1: in vergrößerter Darstellung den Schnitt durch eine Quellenzone entlang der Linie I - I in Fig. 2;
- Fig. 2: einen Querschnitt durch eine Quellenzone gemäß der Schnittlinie II - II in Fig. 1;
- Fig. 3: eine perspektivische Darstellung eines Quellenbehälters mit aufgesetz- tem Deckel;
- Fig. 4: einen Querschnitt durch eine VPE-Beschichtungseinrichtung mit der in Fig. 1 dargestellten Quellenanordnung;
- Fig. 5: eine Darstellung gemäß Fig. 1 eines zweiten Ausführungsbeispiels;
- Fig. 6: eine Darstellung gemäß Fig. 2 des zweiten Ausführungsbeispiels;
- Fig. 7: eine Darstellung gemäß Fig. 1 eines dritten Ausführungsbeispiels;
- Fig. 8: eine Darstellung gemäß Fig. 2 des dritten Ausführungsbeispiels;
- Fig. 9: eine Darstellung gemäß Fig. 1 eines vierten Ausführungsbeispiels und
- Fig. 10: eine Darstellung gemäß Fig. 2 des vierten Ausführungsbeispiels.

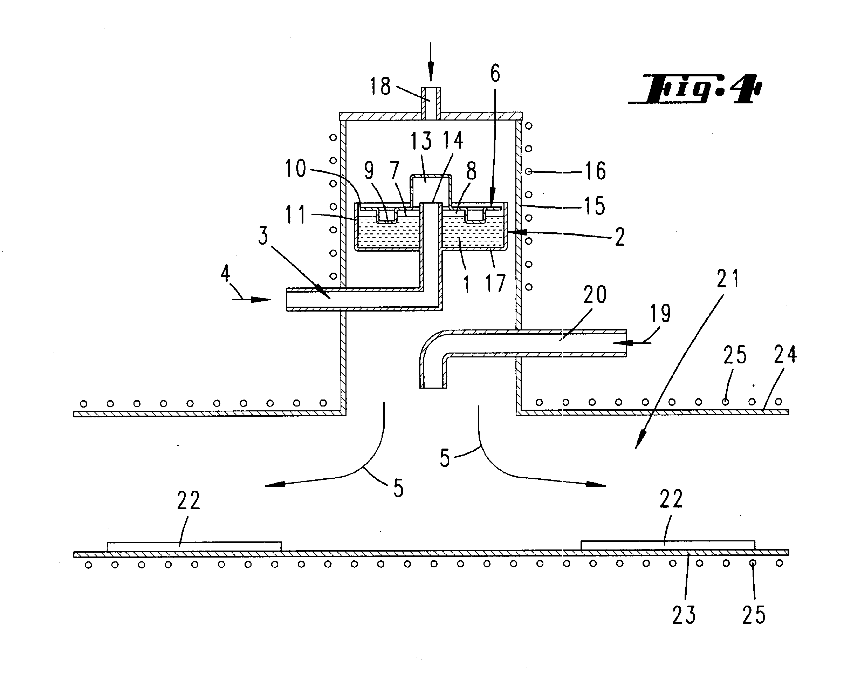

Bei dem in der Figur 4 dargestellten VPE-Reaktor handelt es sich um einen Horizontalreaktor, da sich die Prozesskammer 21 in Horizontalrichtung erstreckt. Der Boden der im wesentlichen kreisförmigen Prozesskammer 21 bildet einen Suszeptor 23 aus. Der Boden wird von unten mit einer Widerstandsheizung 25 beheizt. Es sind auch andere Arten der Beheizung möglich, insbesondere kann eine RF-Heizung verwendet werden. Auf dem kreisscheibenförmigen Boden 23 befinden sich eine Vielzahl Substrate 22. Die Substrate 22 sind in kreisförmiger Anordnung um das Zentrum des Suszeptors 23 anbeordnet.

Oberhalb des Suszeptors 23 befindet sich die Prozesskammerdecke 24. Diese verläuft parallel zum Boden 23 und besitzt im Zentrum eine Öffnung. Die Öffnung liegt außerhalb der Zone des Suszeptors 23, in welcher sich die Substrate 22 befinden. Oberhalb dieser kreisförmigen Öffnung der Prozesskammerdecke 24 befindet sich die Quellenzone. Die Quellenzone besteht aus einem sich in Vertikalrichtung erstreckenden Rohr. Dieses Rohr bildet die Wandung 15 der Quellenzone. Das Rohr ist stirnseitig verschlossen. Dort mündet eine Spülgasleitung 18, durch welche ein Inertgas in die Quellenzone eingeleitet wird. Die Wandung 15 der Quellenzone ist von einer Quellenheizung 16 umgeben. Auch hier handelt es sich vorzugsweise um eine Widerstandsheizung.

Im oberen Bereich der Quellenzone befindet sich ein Behälter 2. In diesen mündet eine Zuleitung 3, durch die HCl als reaktives Gas 4 eingeleitet wird. Unterhalb des Behälters 2 befindet sich eine Zuleitung 20, mit der ein Hydrid als Prozessgas 19 in den unteren Bereich der Quellenzone eingebracht wird.

Der Behälter 2 enthält Metall der III-Hauptgruppe, Gallium, Aluminium oder Indium. Der Behälter 2 besitzt einen Deckel 6. Der Deckel 6 besitzt einen Abstand zur Oberfläche 7 des Ausgangsstoffes 1, der sich im Behälter 2 befindet. Die Zuleitung 3 ragt von unten durch den Boden 17 des Behälters 2, so dass das HCl von unten nach oben in einen Dom 13 des Deckels 6 strömt. Das aus der Mündung 14 der Zuleitung 3 austretende HCl reagiert an der Oberfläche 7 mit dem Metall und bildet ein Prozessgas 5, welches Galliumchlorid, Indiumchlorid oder Aluminiumchlorid sein kann.

Das in der Quelle gebildete Chlorid 5 und das zugeleitete Hydrid 19 strömen von oben zwischen der Außenwandung 11 des Behälters 2 und der Prozesskammerwandung 15 nach unten und dann von oben her in die Prozesskammer 21 ein, werden dort in Radialrichtung umgeleitet und überströmen in Horizontalrichtung das Substrat 22, wobei dort die III- bzw. V-Komponente als einkristalline Schicht abgeschieden werden.

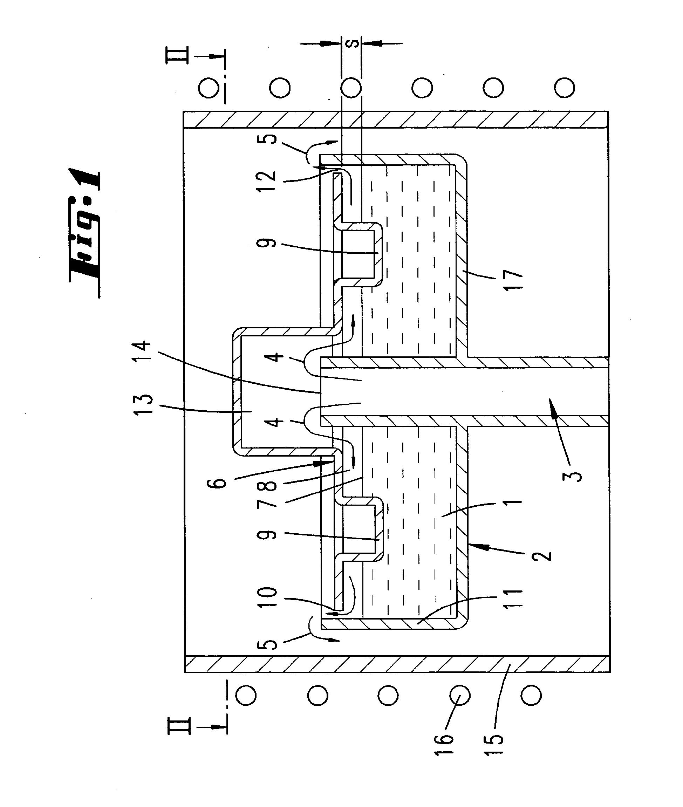

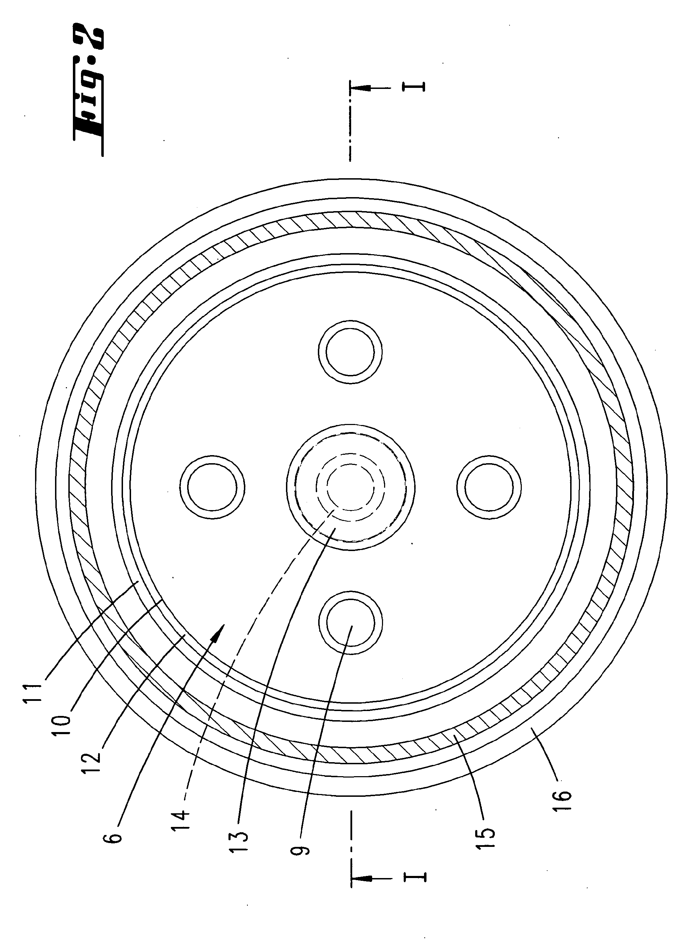

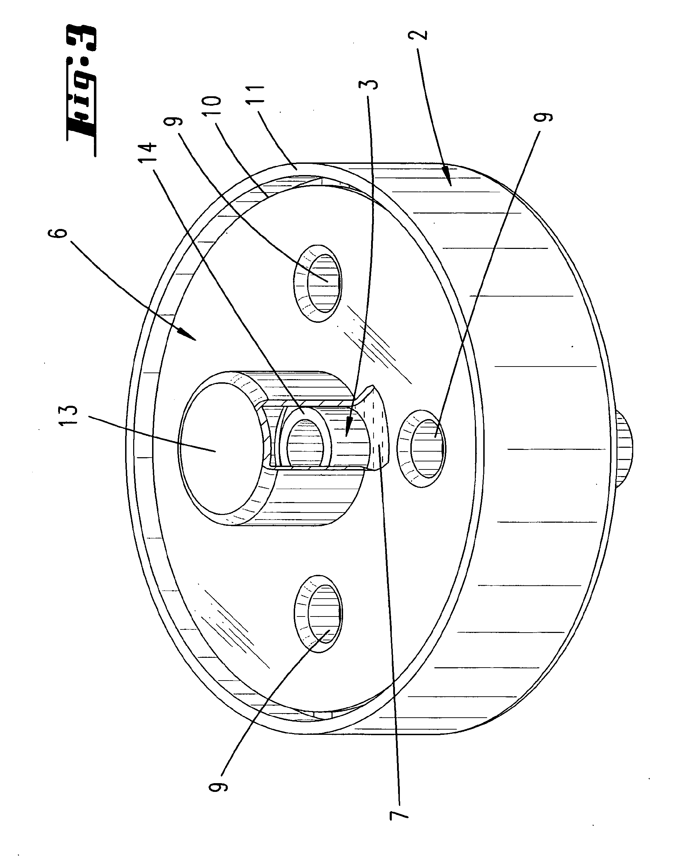

Wie insbesondere den Figuren 1 bis 3 zu entnehmen ist, besitzt die Quelle einen flachen Behälter 2, der aus Quarz, Graphit oder Saphir besteht. Der Behälter 2 besitzt einen sich in Horizontalrichtung erstreckenden, kreisscheibenförmigen Boden 17. Durch das Zentrum des Bodens 17 ragt ein sich in Vertikalrichtung erstreckender Abschnitt der Zuleitung 3. Die Zuleitung 3 besitzt eine Mündung 14. Die Mündung 14 liegt etwa auf der gleichen Höhe wie der Rand der kreisringförmigen Behälterwandung 11. Die im Behälter 2 angeordnete Schmelze 1 aus einem der oben genannten Metalle bildet somit eine kreisringförmige Oberfläche 7.

Innerhalb der Behälterwandung 11 befindet sich ein Deckel 6. Der Deckel 6 besitzt eine kreisförmige Umrisskontur, wobei der Durchmesser des Deckels 6 geringfügig kleiner ist als der Innendurchmesser der Behälterwandung 11. Dies hat zur Folge, dass der Deckelrand 10 einen Abstandsspalt 12 zur Behälterwand 11 freilässt. Durch diesen Abstandsspalt 12 kann das unterhalb des Deckels 6 gebildete Prozessgas 5 dem Behälter entströmen.

Der Deckel 6 schwimmt auf der Schmelze 1. Damit das aus der Zuleitungsmündung 14 austretende reaktive Gas 4 unter dem Deckel 6 entlang strömen kann, besitzt der Deckel 6 nach unten abragende Schwimmer 9. Diese Schwimmer 9 werden von zylinderförmigen Hohlkörpern gebildet. Die Hohlkörper sind nach oben offen. Diese Schwimmer 9 tauchen bereichsweise in die Oberfläche 7 der Schmelze 1 ein. Zwischen den voneinander beabstandeten, im Ausführungsbeispiel insgesamt vier Schwimmern 9 befindet sich die vom reaktiven Gas 4 durchströmbare Zone, in welcher sich das eingeleitete HCl mit dem Metall zu einem Metallchlorid verbindet. Indem der Deckel 6 auf der Oberfläche 7 der Schmelze 1 schwimmt, ist der Abstand zwischen der Unterseite des Deckels 6 und der Oberfläche der Schmelze 7 unabhängig vom Flüssigkeitspegel der Schmelze 1. So wie das Volumen der Schmelze 1 abnimmt, senkt sich der Deckel 6 ab.

Im Zentrum des Deckels 6 befindet sich ein nach oben ragender Dom 13 in Form eines Topfes, der mit seitlichem Abstand die Zuleitungsmündung 14 überfängt. Die Höhe des Domes 13 ist so gewählt, dass der Deckel 6 bis auf ein Minimalvolumen der Schmelze 1 abgesenkt werden kann, ohne dass die Zuleitungsmündung 14 von der Deckelfläche des Domes 13 verschlossen wird.

Beim Ausführungsbeispiel wird der Deckel 6 in Radialrichtung unterströmt. Es sind auch Ausgestaltungen denkbar, bei denen der Deckel 6 linear durchströmt wird. Hierzu kann ein Rand des Deckels 6 in die Schmelze 1 eintauchen, so dass eine Durchströmungsrichtung definiert wird. Derartige, linear durchströmbare Behälter können für Horizontalquellenanordnungen verwendet werden. Die Zuleitung des reaktiven Gases erfolgt dann am Rand des Behälters. Bevorzugt weist der Deckel eines derartigen Behälters einen umlaufenden, nach unten in die Schmelze ragenden Randabschnitt auf, der lediglich abströmseitig offen ist, so dass das sich unter dem einen U-förmigen Querschnitt aufweisenden Deckel gebildete Prozessgas abströmen kann. Auch bei dieser Lösung schwimmt der Deckel auf der Schmelze. Es ist aber auch möglich, dass der Deckel eine Öffnung aufweist, durch die das Prozessgas ausströmen kann.

Auch bei dieser Lösung ist es von Vorteil, wenn vom Deckel 6 nach unten Schwimmer 9 abragen, die von in die Oberfläche der Schmelze 1 eintauchenden Hohlkörpern gebildet sind, so dass eine sich im wesentlichen ebene und in Horizontalrichtung sich erstreckende Deckelunterseite einen Parallelabstand zur Oberfläche 7 der Schmelze besitzt. Hierdurch wird ein unabhängig vom Quellenvolumen gleichbleibendes durchströmbares Reaktionsvolumen 8 gebildet.

Ist das Quellenmaterial bei Quellentemperatur fest, so bilden die in den Zeichnungen mit der Bezugsziffer 9 bezeichneten Schwimmer lediglich Stützen. In diesem Falle reicht es aus, wenn von der Unterseite des Deckels Träger, beispielsweise in Form von Vorsprüngen oder Stiften abragen, die sich auf der Festkörperoberfläche abstützen.

Es wird als wesentlich erachtet, dass sich der Abstand s zwischen der Unterseite des Deckels 6 und der Oberfläche der Schmelze bzw. der Oberfläche des Quellenmaterials während des gesamten Verbrauchs des Quellenmaterials nicht ändert.

Bei dem in den Figuren 1 bis 3 dargestellten Ausführungsbeispiel erfolgt der Zustrom 4 durch einen Spalt zwischen den Seitenwänden des Doms 13 und dem oberen Abschnitt der Zuleitung 3. Der Gasaustritt erfolgt durch einen Spalt 12.

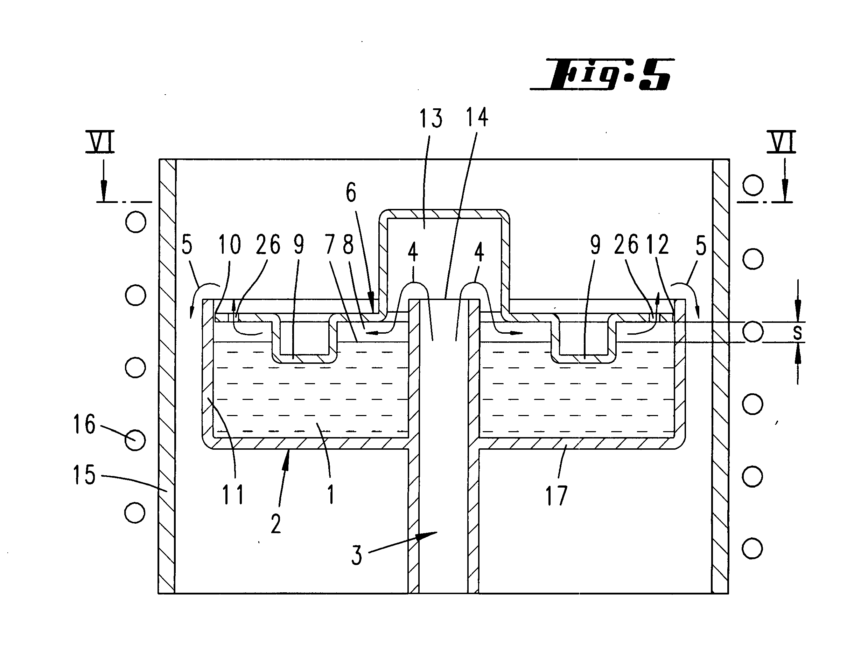

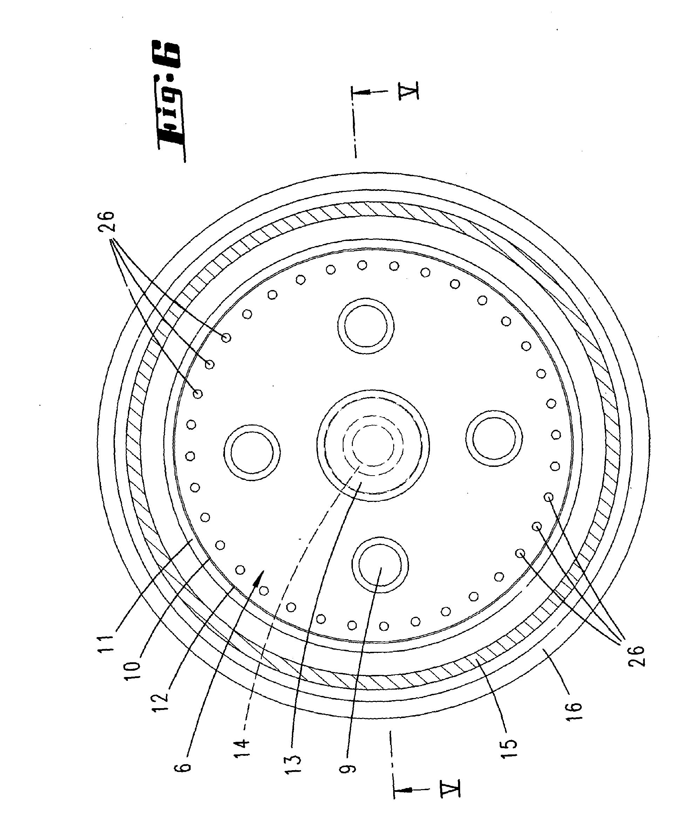

In dem in den Figuren 5 und 6 dargestellten Ausführungsbeispiel ist der Spalt 12 zwischen Deckelrand 10 und Behälterwand 11 minimiert. Er beträgt nur wenige Zehntel Millimeter (0,1 bis 0,5 mm). Der Abstrom erfolgt jetzt durch im Bereich des Deckelrandes 10 angeordnete Austrittsöffnungen 26. Wie der Figur 6 zu entnehmen ist, sind diese Öffnungen 26 gleichmäßig über den gesamten Umfang des Deckels 6 verteilt angeordnet. Durch den nur sehr geringen Spalt 12 ist die Lage des Deckels 6 in Bezug auf das Zentrum des Behälters 2 justiert.

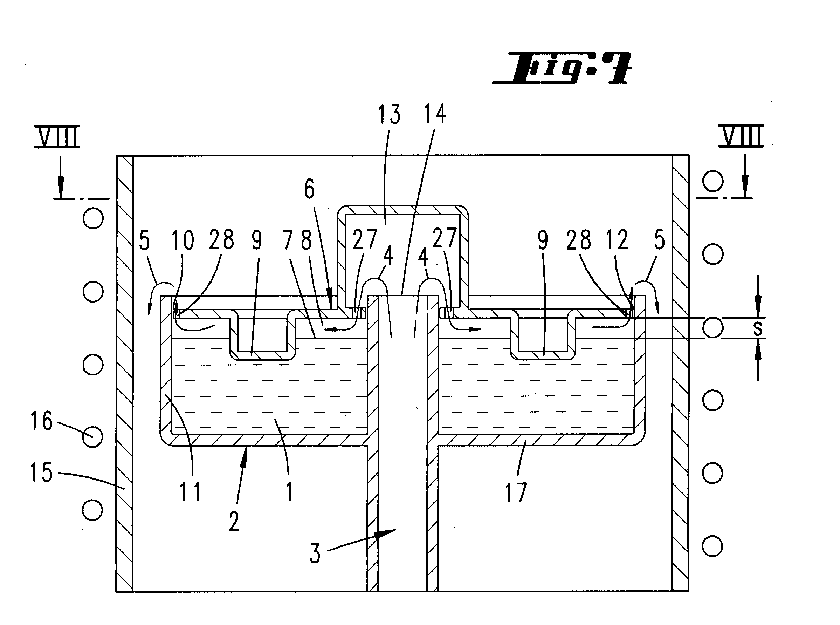

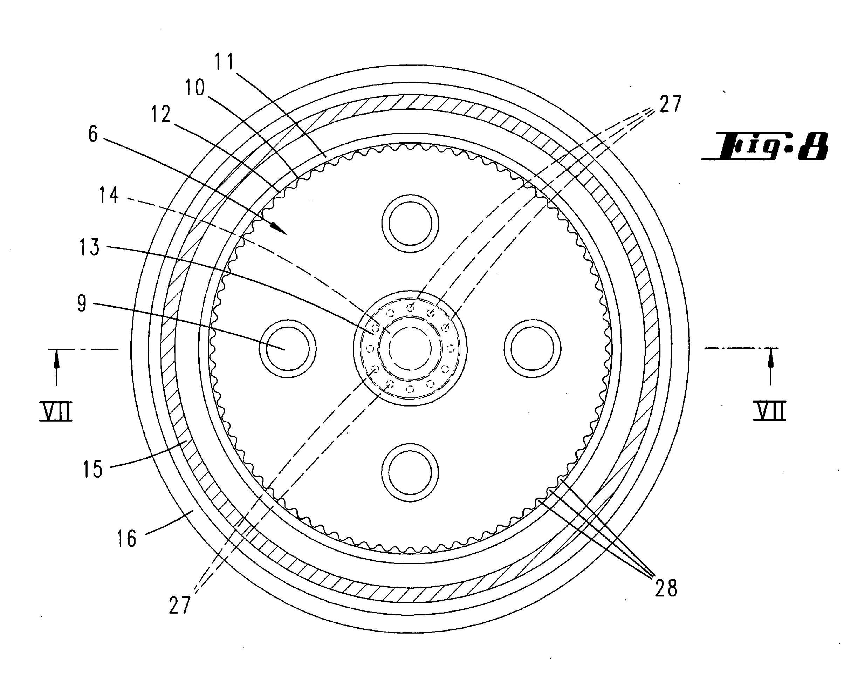

Das in den Figuren 7 und 8 dargestellte dritte Ausführungsbeispiel zeigt eine Alternative zur Zentrierung des Deckels 6. Der Dom 13 besitzt im unteren Bereich einen einwärts gerichteten Kragen. Dieser Kragen besitzt Eintrittsöffnungen 27, durch die das aus der Zuleitung 3 strömende Gas in den Bereich unter den Deckel 6 strömen kann. Der Kragen liegt etwa auf Höhe der Deckelscheibe. Der Abstand zwischen Innenrand des Kragens und dem oberen Abschnitt der Zuleitung 3 beträgt auch hier wenige Zehntel Millimeter. Der äußere Rand 10 des Deckels 6 besitzt hier Ausbuchtungen 28. Der Deckel ist somit zahnradartig gestaltet. Die die Ausbuchtungen 28 zwischen sich ausbildenden Vorsprünge besitzen gerundete Scheitel, die mit wenigen Zehntel Millimetern von der Behälterwandung 11 entfernt liegen. Auch die Böden der Ausbuchtungen sind gerundet.

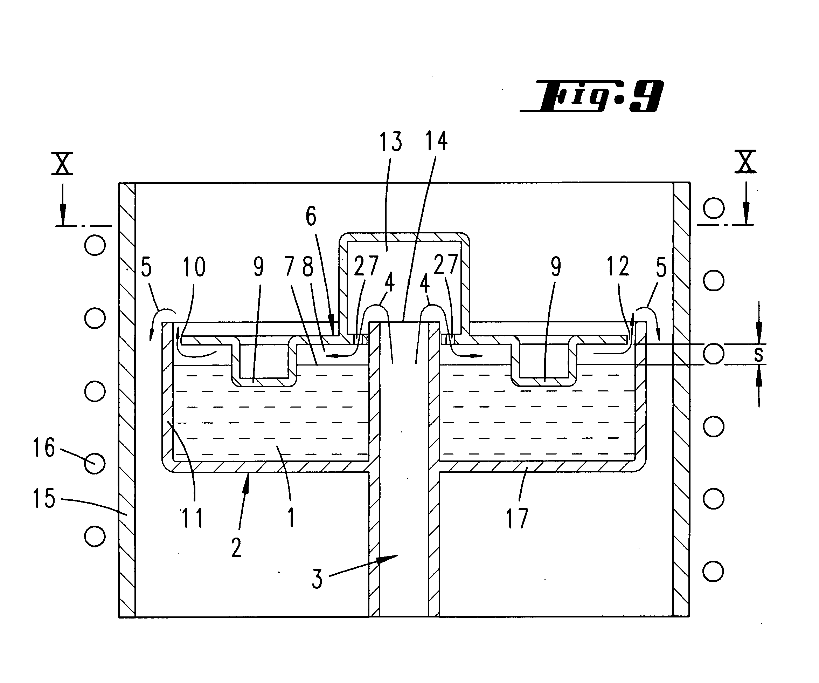

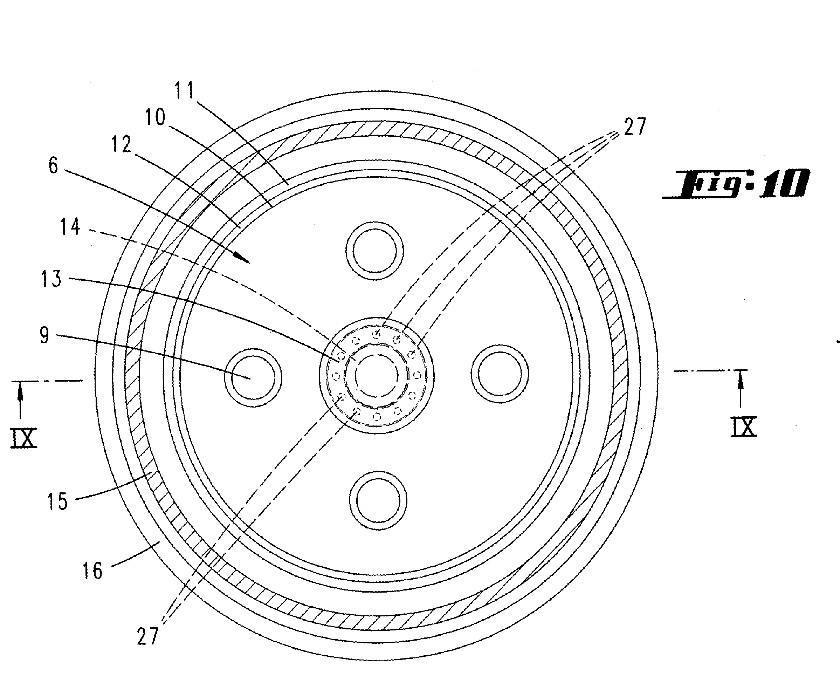

Bei dem in den Figuren 9 und 10 dargestellten Ausführungsbeispiel erfolgt der Abstrom über einen Abstandsspalt 12. Die Zentrierung des Deckels 6 erfolgt hier über den Kragen unterhalb des Domes 13. In einem nicht dargestellten weiteren Ausführungsbeispiel kann der Abstrom des Gases aber auch durch Öffnungen 26 erfolgen, wie dies im Ausführungsbeispiel der Figuren 5 und 6 dargestellt ist.

## Patentansprüche

1. Quellenanordnung für eine VPE-Beschichtungseinrichtung mit einem einen flüssigen oder festen Ausgangsstoff (1) beinhaltenden, nach oben eine Öffnung aufweisenden Behälter (2), mit einer Zuleitung (3) für ein reaktives Gas (4), das mit dem Ausgangsstoff (1) zur Bildung eines den Ausgangsstoff aufweisenden Prozessgases (5) reagiert, mit einem Deckel (6) zwischen sich und der Oberfläche (7) des Ausgangsstoffes (1) ein vom reaktiven Gas (4) parallel zur Oberfläche (7) durchströmbares Volumen (8) ausbildet, in welches eine Zuleitung (3) mündet, **dadurch gekennzeichnet, dass** der Deckel (6) unmittelbar auf dem Ausgangsstoff (1) aufliegt.

2. Quellenanordnung nach Anspruch 1, **dadurch gekennzeichnet, dass** der Deckel (6) auf dem Ausgangsstoff (1) schwimmt.

3. Quellenanordnung nach Anspruch 1, **gekennzeichnet durch** nach unten vom Deckel (6) abragende Träger, insbesondere Schwimmer (9).

4. Quellenanordnung nach einem der vorangehenden Ansprüche, **gekennzeichnet durch** eine zentrale Zuleitung (3), die vom Deckel (6) überfangen wird, wobei das Volumen (8) in Radialrichtung durchströmt ist.

5. Quellenanordnung nach einem der vorangehenden Ansprüche, **gekennzeichnet durch** einen Abstand des Randes (10) des Deckels (6) von der Behälterwand (11), wobei das gebildete Prozessgas (5) **durch** diesen Abstandsspalt (12) strömt.

6. Quellenanordnung nach einem der vorangehenden Ansprüche, **gekennzeichnet durch** eine von unten in einen zentralen Boden (13) des Deckels (6) ragende Zuleitungsmündung (14).

7. Quellenanordnung nach einem der vorangehenden Ansprüche, **dadurch gekennzeichnet, dass** der Behälter (2) und der Deckel (6) aus Quarz, Graphit, Bornitrit oder Saphir bestehen.

8. VPE-Beschichtungsvorrichtung mit einer Prozesskammer (21) und einer dieser in Strömungsrichtung eines Prozessgases vorgeordneten Quellenzone, in welcher Quellenzone sich ein einen flüssigen oder festen Ausgangsstoff (1) beinhaltender, nach oben eine Öffnung aufweisender Behälter (2) und eine Zuleitung (3) für ein reaktives Gas (4) befindet, mit einem Deckel (6), welcher zwischen sich und der Oberfläche (7) ein vom reaktiven Gas durchströmbares Volumen (8) ausbildet, **dadurch gekennzeichnet, dass** der Deckel (6) unmittelbar auf dem Ausgangsstoff (1) aufliegt.

9. VPE-Beschichtungsvorrichtung nach Anspruch 8, **gekennzeichnet durch** eine vertikal durchströmte Quellenzone.

10. VPE-Beschichtungsvorrichtung nach einem der Ansprüche 8 oder 9, **dadurch gekennzeichnet, dass** die Quellenzone vertikal oberhalb der Prozesskammer angeordnet ist.

11. VPE-Beschichtungsvorrichtung nach einem der Ansprüche 8 bis 10, **dadurch gekennzeichnet, dass** die Quellenzone eine Quellenzonenheizung (16) und die Prozesskammer (21) eine Prozesskammerheizung (25) aufweist.

12. VPE-Beschichtungsvorrichtung nach einem der Ansprüche 8 bis 11, **gekennzeichnet durch** eine im wesentlichen rotationssymmetrische Prozesskammer (21) und eine dem Zentrum der Prozesskammer (21) zugeordnete Quellenzone, wobei die von der Prozesskammer (21) aufgenommenen Substrate (22) um das Zentrum der Prozesskammer (21) herum angeordnet sind.

## Claims

1. A source arrangement for a VPE deposition apparatus, comprising a container (2) containing a liquid or solid starting material (1) and having a top opening, comprising a feed line (3) for a reactive gas (4), which reacts with the starting material (1) in order to produce a process gas (5) that contains the starting material, and comprising a cover (6) which defines between itself and the surface (7) of the starting material (1) a volume (8) through which the reactive gas (4) can flow parallel to the surface (7) and into which there opens a feed line (3), **characterized in that** the cover (6) rests directly on the starting material (1).

2. A source arrangement according to Claim 1, **characterized in that** the cover (6) floats on the starting material (1).

3. A source arrangement according to Claim 1, **characterized by** carriers, in particular floats (9), protruding down from the cover (6).

4. A source arrangement according to any of the preceding claims, **characterized by** a central feed line (3), which is overlaid by the cover (6), the flow passing through the volume (8) in a radial direction.

5. A source arrangement according to any of the preceding claims, **characterized by** the periphery (10) of the cover (6) being at a spacing from the container wall (11), the process gas (5) that is formed flowing through this space or gap (12).

6. A source arrangement according to any of the preceding claims, **characterized by** a feed line outlet (14) protruding from below into a central base (13) of the cover (6).

7. A source arrangement according to any of the preceding claims, **characterized in that** the container (2) and the cover (6) consist of quartz, graphite, boron nitrite or sapphire.

8. A VPE deposition device comprising a process chamber (21) and a source zone arranged upstream in the direction of flow of a process gas, in which source zone there is a feed line (3) for a reactive gas (4) and a container (2) containing a liquid or solid starting material (1) and having a top opening, and the device also comprising a cover (6) which defines between itself and the surface (7) a volume (8) through which the reactive gas can flow, **characterized in that** the cover (6) rests directly on the starting material (1).

9. A VPE deposition device according to Claim 8, **characterized by** a source zone through which the flow can pass vertically.

10. A VPE deposition device according to either of Claims 8 and 9, **characterized in that** the source zone is disposed vertically above the process chamber.

11. A VPE deposition device according to any of Claims 8 to 10, **characterized in that** the source zone has a source zone heater (16) and the process chamber (21) has a process chamber heater (25).

12. A VPE deposition device according to any of Claims 8 to 11, **characterized by** a substantially rotationally symmetrical process chamber (21) and a source zone associated with the centre of the process chamber (21), the substrates (22) that are received by the process chamber (21) being disposed around the centre of the process chamber (21).

## Revendications

1. Système source pour un dispositif de revêtement VPE comportant un récipient (2), qui présente une ouverture vers le haut et qui contient une matière de départ (1) liquide ou solide, une conduite d'amenée (3) destinée à un gaz réactif (4) qui réagit avec la matière de départ (1) pour former un gaz de réaction (5) possédant la matière de départ, un couvercle (6) qui forme entre lui-même et la surface (7) de la matière de départ (1) un volume (8) qui est apte à être traversé parallèlement à la surface (7) par le gaz réactif (4) et dans lequel débouche une conduite d'amenée (3), **caractérisé en ce que** le couvercle (6) est placé directement sur la matière de départ (1).

2. Système source selon la revendication 1, **caractérisé en ce que** le couvercle (6) flotte sur la matière de départ (1).

3. Système source selon la revendication 1, **caractérisé par** des supports, notamment des flotteurs (9), saillant vers le bas depuis le couvercle (6).

4. Système source selon l'une des revendications précédentes, **caractérisé par** une conduite d'amenée centrale (3) sur laquelle est plaqué le couvercle (6), le volume (8) étant traversé dans une direction radiale.

5. Système source selon l'une des revendications précédentes, **caractérisé par** un espacement entre le bord (10) du couvercle (6) et la paroi (11) du récipient, le gaz de réaction formé (5) s'écoulant par cette fente d'espacement (12).

6. Système source selon l'une des revendications précédentes, **caractérisé par** une embouchure de conduite d'amenée (14) saillant depuis le bas jusque dans un fond central (13) du couvercle (6).

7. Système source selon l'une des revendications précédentes, **caractérisé en ce que** le récipient (2) et le couvercle (6) sont en quartz, en graphite, en nitrure de bore ou en saphir.

8. Dispositif de revêtement VPE comportant une chambre de réaction (21) et une zone source située en amont de celle-ci par référence à la direction d'écoulement d'un gaz de réaction, zone source dans laquelle se trouvent un récipient (2) présentant une ouverture vers le haut et contenant une matière de départ (1) liquide ou solide et une conduite d'amenée (3) destinée à un gaz réactif (4), un couvercle (6) qui forme entre lui-même et la surface (7) un volume (8) pouvant être traversé par le gaz réactif, **caractérisé en ce que** le couvercle (6) est placé directement sur la matière de départ (1).

9. Dispositif de revêtement VPE selon la revendication 8, **caractérisé par** une zone source traversée verticalement.

10. Dispositif de revêtement VPE selon l'une des revendications 8 ou 9, **caractérisé en ce que** la zone source est disposée verticalement au-dessus de la chambre de réaction.

11. Dispositif de revêtement VPE selon l'une des revendications 8 à 10, **caractérisé en ce que** la zone source possède un dispositif de chauffage de zone source (16) et la chambre de réaction (21) possède un dispositif de chauffage de chambre de réaction (25).

12. Dispositif de revêtement VPE selon l'une des revendications 8 à 11, **caractérisé par** une chambre de réaction (21) sensiblement à symétrie de révolution et une zone source associée au centre de la chambre de réaction (21), les substrats (22) reçus par la chambre de réaction (21) étant disposés autour du centre de la chambre de réaction (21).
